# EUROPÄISCHE PATENTSCHRIFT

(11) **EP 2 598 799 B1**
(45) Veröffentlichungstag und Bekanntmachung des Hinweises auf die Patenterteilung: **07.07.2021**
(21) Anmeldenummer: 11745769.7
(22) Anmeldetag: 16.08.2011
(51) Int. Cl.: F22B 37/10, F22B 37/04

(54) **VORRICHTUNG ZUM BETREIBEN EINES KREISLAUFSYSTEMS UND VERFAHREN ZUM BESCHICHTEN VON GENERATOR- UND/ODER TURBINENSCHAUFELN UND/ODER KONDENSATORROHRBÖDEN EINES KRAFTWERKSKONDENSATORS**
DEVICE FOR OPERATING A CIRCULATION SYSTEM AND COATING METHOD OF GENERATOR AND/OR TURBINE BLADES AND/OR CONDENSER TUBE SHEETS OF A POWER PLANT CONDENSER
SYSTÈME DE CIRCULATION ET PROCÉDÉ DE REVÊTEMENT D'AUBES DE GÉNÉRATEUR ET/OU DE TURBINE ET/OU D'UNE PLAQUE TUBULAIRE D'UN CONDENSEUR DE CENTRALE ÉLECTRIQUE

(30) Priorität: 09.09.2010 DE 102010044859
(43) Veröffentlichungstag der Anmeldung: 05.06.2013
(73) Patentinhaber: Siemens Energy Global GmbH & Co. KG, 81739 München (DE)
(72) Erfinder: EDER, Florian, 91052 Erlangen (DE)
(86) Internationale Anmeldenummer: PCT/EP2011/064110
(87) Internationale Veröffentlichungsnummer: WO 2012/031862

(56) Entgegenhaltungen:
- EP-A1- 1 652 955
- EP-A1- 1 867 838
- WO-A1-01/18274
- WO-A2-2009/088934
- GB-A- 2 009 621
- US-A- 4 098 324
- None

## Beschreibung

Die Erfindung betrifft eine Vorrichtung zum Betreiben eines Kreislaufsystems, insbesondere einen Kraftwerkskondensator, eine Turbine und/oder einen Generator. Die Erfindung betrifft auch ein Verfahren zum Beschichten der Innenoberflächen einer derartigen Vorrichtung.

Generatorinnenflächen, Turbinenschaufel und/oder Kondensationsflächen von Kraftwerkskondensatoren, beispielsweise Rohre von Kraftwerkskondensatoren für Dampfturbinen, werden aus teuren Materialien, wie besonders korrosionsbeständigen Metallen oder Legierungen, z.B. Titanlegierungen oder Edelstahl, hergestellt.

Um die Kosten zu senken, werden die Kondensationsflächen eines Kraftwerkskondensators genau berechnet, weil wertvolle Rohstoffe und Montageaufwand eingespart werden. Deshalb ist es hier besonders wichtig, dass die vorhandenen Flächen mit optimaler Effizienz nutzbar gemacht werden.

Eine Art der Effizienzsteigerung der besagten Oberflächen, beispielsweise der Kondensatoroberflächen, ist, die Kondensationsoberfläche zu beschichten, damit Filmkondensation, die einen zusätzlichen Widerstand beim Wärmeübergang bedeutet, vermieden und eine gute Tropfenkondensation fördernde Oberfläche erhalten wird.

Aktuelle Untersuchungen zeigen, dass neben einer guten Tropfenkondensation fördernden Oberflächenbeschaffenheit, also beispielsweise Hydrophobie der Oberflächenbeschichtung, vor allem auch noch die Schichtdicke der Kondensationsflächenbeschichtung für die Effizienz der Vorrichtung eine Rolle spielt; sie sollte möglichst klein sein, damit Effizienzverluste durch Wärmeleitungsverlust aufgrund einer dicken Beschichtung vermieden wird.

Es werden bevorzugt hydrophobe Oberflächenbeschichtungen eingesetzt, weil diese anstatt einer Filmkondensation eine Tropfenkondensation des Turbinendampfes bewirken, durch die effizienter kondensiert wird als durch Filmkondensation.

Aus der EP 1867838A1 ist ein Verfahren zur Substitution eines Materials einer Beschichtung bekannt, bei dem die Gasturbinenschaufeln geladen werden und das Material dann mit dem Gasstrom mit umgekehrter Polung in den Turbinenraum eingespeist wird.

Aus der WO 2009/088934 A2 ist ein Verfahren zur Beschichtung metallischer Oberflächen bekannt, bei dem ein Metallpulver auf ein metallisches Substrat aufgebracht wird und dieses dann einem Plasma ausgesetzt wird.

Aus der WO 2001/18274 A1 ist ein Verfahren zur Beschichtung von Gasturbinen-Oberflächen bekannt, bei dem in-situ durch ein Luft-gestütztes Plasmaverfahren eine BarriereBeschichtung aufbringbar ist.

Nachteilig an den dünnen, bevorzugt hydrophoben, Oberflächenbeschichtungen in geschlossenen Vorrichtungen, also Vorrichtungen zum Betreiben eines Kreislaufsystems, wie beispielsweise in Kraftwerkskondensatoren, ist deren Lebensdauer bei Betrieb. Beispielsweise in einem Kraftwerkskondensator zeigen diese Beschichtungen nur geringe Halbwertszeit, weil es dort eine ständige, kombiniert Chemomechanische Belastung der Beschichtung - einmal chemisch durch Hydrolyse oder Wassereinlagerungseffekte und zum anderen mechanisch durch den vorbeiströmenden Turbinendampf und kleinste Tröpfchen - herrscht, die diese, insbesondere weil sie dünn ist, beschädigt oder zerstört.

Als Folge davon tritt Effizienzverlust ein, der vermieden werden sollte.

Aufgabe der vorliegenden Erfindung ist es deshalb, eine Vorrichtung zum Betreiben eines Kreislaufsystems mit zumindest teilweise einer dünnen und möglichst kostengünstig herstellbaren, erneuerbaren und/oder reparablen Oberflächenbeschichtung der inneren Oberflächen zu schaffen.

Die Lösung der Aufgabe wird durch die Beschreibung und die Ansprüche offenbart.

Demgemäß ist Gegenstand der Erfindung eine Vorrichtung zum Betreiben eines Kreislaufs, wobei die Vorrichtung zwei Elektroden und einen Gaseinlass hat, dazu einen Innenraum mit zu beschichtenden inneren Oberflächen umfassend, wobei die inneren Oberflächen zumindest zum Teil elektrisch leitfähig, insbesondere aus metallischem Material, sind, wobei die Vorrichtung funktionsbedingt gut abgedichtet ist und zumindest eine innere Oberfläche im Innenraum der Vorrichtung durch Kontaktierung als Elektrode zur Erzeugung eines Plasmas nutzbar ist und durch das Plasma zumindest eine der inneren Oberflächen der Vorrichtung beschichtbar ist. Zudem ist Gegenstand der Erfindung das dazugehörige Verfahren zur Beschichtung der inneren Oberflächen der Vorrichtung folgende Verfahrensschritte umfassend: - Einbringen eines Precursorgases in die Vorrichtung zum Betreiben eines Kreislaufsystems, - Einbringen eines Reaktionsgases zu dem Precursorgas in die Vorrichtung, - Kontaktieren einer Elektrode und einer Gegenelektrode, - Einschalten eines Plasmafrequenzgenerators, Einkoppeln der Frequenz und Zünden des Plasmas.

Allgemeine Erkenntnis der Erfindung ist es, dass eine optimale Beschichtung durch Plasma erzeugbar ist und jede Vorrichtung zum Betreiben eines Kreislaufs, wie ein Kraftwerkskondensator, sowie das Innere einer Turbine und/oder eines Generators, inklusive deren Turbinen- und/oder Generatorschaufeln prinzipiell zur Erzeugung eines Plasmas gut geeignet ist, weil er funktionsbedingt bereits gut abgedichtet ist, da er beispielsweise unter Luftausschluss betrieben wird und mit einem entsprechenden Pumpsystem ausgestattet ist.

Nach einer vorteilhaften Ausführungsform der Erfindung sind die zu beschichtenden inneren Oberflächen der Vorrichtung zum Betreiben eines Kreislaufsystems eine Kondensationsfläche eines Kraftwerkskondensators beispielsweise Rohre, also Kondensatorrohre.

Des Weiteren wurde erkannt, dass beispielsweise bereits die senkrecht zu den Kondensatorrohren liegenden Rohrböden, die parallel zueinander angeordnet sind, als Elektroden für die Zündung eines Radio-Frequenz-Plasmas benutzbar sind.

Nach einer anderen Ausführungsform werden sonstige elektrisch leitende sich in gewissem Abstand gegenüberliegende Platten oder Rohrbündel des Kraftwerkskondensators als Elektroden zur Erzeugung des Plasmas, beispielsweise eines Niederdruckplasmas genutzt.

Nach wieder einer anderen Ausführungsform werden Elektroden in den Kraftwerkskondensator eingebracht, um dort das Plasma zu erzeugen.

Nach einer vorteilhaften Ausführungsform werden die Kondensatorrohre von den Rohrböden elektrisch entkoppelt, beispielsweise durch den Einbau von elektrisch isolierenden Einsätzen, beispielsweise Einsätze aus Kunststoff.

Nach einer vorteilhaften Ausführungsform sind ein oder mehrere Gaseinlässe vorgesehen, durch die beispielsweise Precursorgas für das Plasma, wie beispielsweise Methan, Acetylen, Hexan in das Kondensatorrohrinnere geleitet wird.

Durch die gleichen oder andere Gaseinlässe können dann die entsprechenden Reaktionsgase wie Stickstoff, Sauerstoff oder Wasserstoff mit den Precursorgasen gemischt und gleichmäßig verteilt werden.

Die Gasmischung im Kondensatorrohr wird dann lokal oder im gesamten Volumen gezündet, so dass sich auf den Kondensatorrohrinnenwänden die gewünschte Beschichtung bildet.

Nach einer vorteilhaften Ausführungsform des Verfahrens wird im Kraftwerkskondensator ein Niederdruckplasma zur Beschichtung der Kondensationsflächen erzeugt.

Die Zündung des Plasmas kann durch eine Gaslanze komplett oder durch die Versorgung von zwei oder mehr Rohrböden mit Radiofrequenz lokal erfolgen.

Die lokale Zündung hat den Vorteil, dass nur ein relativ geringer apparativer Aufwand eine Neubeschichtung ermöglicht, da beispielsweise ein Kontaktieren eines Plasmafrequenzgenerators und eine dazugehörige Gaszufuhr zur Erneuerung oder Reparatur der Beschichtung ausreichen.

Die Erfindung betrifft eine Vorrichtung zum Betreiben eines Kreislaufsystems, Verfahren zur Beschichtung einer derartigen Vorrichtung. Insbesondere betrifft die Erfindung einen multifunktionellen Kraftwerkskondensator, insbesondere einen mit beschichteten Kondensationsflächen. Das Innere eines Kraftwerkskondensators wird dabei durch Kontaktieren von Elektroden und Einführung von Plasmagasen zur Erzeugung und/oder zum Zünden eines Plasmas genutzt, durch das eine Beschichtung auf den Innenflächen, den Kondensationsflächen des Kraftwerkskondensators erzeugbar ist.

## Patentansprüche

1. Vorrichtung zum Betreiben eines Kreislaufs, wobei die Vorrichtung zwei Elektroden und einen Gaseinlass hat, dazu einen Innenraum mit zu beschichtenden inneren Oberflächen umfassend, wobei die inneren Oberflächen zumindest zum Teil elektrisch leitfähig, insbesondere aus metallischem Material, sind, **dadurch gekennzeichnet, dass** die Vorrichtung funktionsbedingt abgedichtet ist und zumindest eine innere Oberfläche im Innenraum der Vorrichtung durch Kontaktierung als Elektrode zur Erzeugung eines Plasmas nutzbar ist und durch das Plasma zumindest eine der inneren Oberflächen der Vorrichtung beschichtbar ist.

2. Vorrichtung nach Anspruch 1, wobei die Vorrichtung ein Kraftwerkkondensator, eine Turbine oder ein Generator ist.

3. Vorrichtung nach einem der Ansprüche 1 oder 2, wobei zumindest eine zu beschichtende innere Oberfläche der Vorrichtung ein Kondensatorrohr, eine Kondensationsfläche, eine Turbinen- und/oder Generator-Schaufel ist.

4. Vorrichtung, insbesondere Kraftwerkskondensator, nach einem der vorstehenden Ansprüche, wobei zumindest eine innere Oberfläche, die durch Kontaktierung als Elektrode zur Erzeugung eines Plasmas nutzbar ist, ein senkrecht zu einem Kondensatorrohr liegender Rohrboden ist.

5. Vorrichtung, insbesondere Kraftwerkskondensator, nach einem der vorstehenden Ansprüche, wobei zwischen zumindest einem Kondensatorrohr, das zu beschichten ist und zumindest einem Rohrboden, der als Elektrode zur Erzeugung des Plasmas eingesetzt ist, ein elektrisch isolierender Einsatz vorgesehen ist.

6. Vorrichtung nach einem der vorstehenden Ansprüche 1 bis 5, bei dem ein oder mehrere Gaseinlässe, durch die Precursorgas für das Plasma in den Innenraum der Vorrichtung einleitbar ist, vorgesehen sind.

7. Vorrichtung nach einem der vorstehenden Ansprüche, wobei die zu beschichtenden inneren Oberflächen aus Titanlegierung und/oder Edelstahl sind.

8. Verfahren zur Beschichtung einer Vorrichtung nach einem der vorstehenden Ansprüche 1 bis 7 folgende Verfahrensschritte umfassend: - Einbringen eines Precursorgases in den Innenraum der Vorrichtung, - Einbringen eines Reaktionsgases zum Precursorgas in den Innenraum der Vorrichtung, - Kontaktieren einer Elektrode und einer Gegenelektrode im Innenraum der Vorrichtung, - Einschalten eines Plasmafrequenzgenerators und Zünden des Plasmas.

9. Verfahren nach Anspruch 8, das als Niederdruckplasma geführt wird.

## Claims

1. Device for operating a circulation system, the device having two electrodes and a gas inlet, additionally comprising an interior space with inner surfaces to be coated, the inner surfaces being at least partly electrically conductive, in particular of metallic material, **characterized in that** the device is functionally sealed and at least one inner surface in the interior space of the device can be used for generating a plasma by contacting as an electrode and at least one of the inner surfaces of the device can be coated by the plasma.

2. Device according to Claim 1, the device being a power plant condenser, a turbine or a generator.

3. Device according to either of Claims 1 and 2, at least one inner surface to be coated of the device being a condenser tube, a condensation surface, a turbine blade and/or a generator blade.

4. Device, in particular a power plant condenser, according to one of the preceding claims, at least one inner surface that can be used for generating a plasma by contacting as an electrode being a tube sheet perpendicular to a condenser tube.

5. Device, in particular a power plant condenser, according to one of the preceding claims, an electrically insulating insert being provided between at least one condenser tube that is to be coated and at least one tube sheet that is used as an electrode for generating the plasma.

6. Device according to one of the preceding Claims 1 to 5, in which one or more gas inlets through which precursor gas for the plasma can be introduced into the interior space of the device are provided.

7. Device according to one of the preceding claims, the inner surfaces to be coated being of titanium alloy and/or high-grade steel.

8. Method for coating a device according to one of the preceding Claims 1 to 7 comprising the following method steps: - introducing a precursor gas into the interior space of the device, - introducing a reaction gas with respect to the precursor gas into the interior space of the device, - contacting an electrode and a counter electrode in the interior space of the device, - switching on a plasma frequency generator and igniting the plasma.

9. Method according to Claim 8, which is used for low-pressure plasma.

## Revendications

1. Dispositif pour faire fonctionner un circuit, le dispositif ayant deux électrodes et une entrée pour du gaz, comprenant à cet effet un espace intérieur ayant des surfaces intérieures à revêtir, les surfaces intérieures étant, au moins en partie, conductrices de l'électricité, en étant notamment en matériau métallique, **caractérisé en ce que** le dispositif est étanche par fonction et au moins une surface intérieure à l'intérieur du dispositif peut être utilisée, par mise en contact comme électrode, pour la production d'un plasma et par le plasma au moins l'une des surfaces intérieures du dispositif peut être revêtue.

2. Dispositif suivant la revendication 1, dans lequel le dispositif est un condenseur de centrale électrique, une turbine ou un générateur.

3. Dispositif suivant l'une des revendications 1 ou 2, dans lequel au moins l'une des surfaces intérieures à revêtir du dispositif est un tube de condenseur, une surface de condensation, une aube de turbine et/ou une aube de générateur.

4. Dispositif, notamment condenseur de centrale électrique, suivant l'une des revendications précédentes, dans lequel au moins une surface intérieure, qui peut être utilisée, par mise en contact comme électrode pour la production d'un plasma, est une plaque tubulaire perpendiculaire à un tube de condenseur.

5. Dispositif, notamment condenseur de centrale électrique, suivant l'une des revendications précédentes, dans lequel un insert isolant électriquement est prévu entre au moins un tube de condenseur, qui doit être revêtu, et au moins une plaque tubulaire, qui est utilisée comme électrode pour la production du plasma.

6. Dispositif suivant l'une des revendications 1 à 5 précédentes, dans lequel il est prévu une entrée de gaz ou plusieurs entrées de gaz, par laquelle ou par lesquelles le gaz précurseur du plasma peut être introduit dans l'espace intérieur du dispositif.

7. Dispositif suivant l'une des revendications précédentes, dans lequel les surfaces intérieures à revêtir sont en alliage de titane et/ou en acier fin.

8. Procédé de revêtement d'un dispositif suivant l'une des revendications précédentes 1 à 7, comprenant les stades de procédé suivants : - Introduction d'un gaz précurseur dans l'espace intérieur du dispositif, - Introduction d'un gaz de réaction avec le gaz précurseur dans l'espace intérieur du dispositif, - Mise en contact d'une électrode et d'une contre-électrode dans l'espace intérieur du dispositif, - Mise en circuit d'un générateur de fréquences de plasma et amorçage du plasma.

9. Procédé suivant la revendication 8, qui est effectué en plasma à basse pression.
